# EUROPEAN PATENT SPECIFICATION

(11) **EP 0 635 885 B1**
(45) Date of publication and mention of the grant of the patent: **16.12.1998**
(21) Application number: 93305793.7
(22) Date of filing: 22.07.1993
(51) Int. Cl.: H01L 23/538, H01L 21/768, H01L 21/48

(54) **High density circuit assembly**
Integriertes Schaltungsbauelement hoher Dichte
Ensemble de circuit intégré à haute densité

(43) Date of publication of application: 25.01.1995
(73) Proprietor: Raytheon Company, El Segundo, California 90245 (US)
(72) Inventor: Gates,James L., Portland,Oregon 97224 (US)
(74) Representative: Colgan, Stephen James

(56) References cited:
- US-A- 5 227 013
- PATENT ABSTRACTS OF JAPAN vol. 017, no. 356 (E-1394)6 July 1993 & JP-A-50 55 455 ( SEIKO INSTR. INC. ) 5 March 1993
- PATENT ABSTRACTS OF JAPAN vol. 013, no. 002 (E-700)6 January 1989 & JP-A-63 213 943 ( SHARP CORP ) 6 September 1988
- PATENT ABSTRACTS OF JAPAN vol. 013, no. 136 (E-737)5 April 1989 & JP-A-63 300 510 ( AGENCY OF IND. SCIENCE & TECHNOL. ) 7 December 1988
- PATENT ABSTRACTS OF JAPAN vol. 010, no. 313 (E-448)24 October 1986 & JP-A-61 125 150 ( AGENCY OF IND. SCIENCE & TECHNOL. ) 12 June 1986

## Description

This invention relates to high density circuit packages, and more particularly to three-dimensional circuit assemblies and fabrication techniques for packaging either multiple integrated circuit layers as a unitary assembly, or a focal plane array together with associated readout circuitry.

In an attempt to increase the density of integrated circuit (IC) packages, efforts have been made to incorporate multiple circuit layers within the same package, with various mechanisms for interconnecting the different layers and providing externally accessible input/output ports. In a similar vein, effort has also been directed towards integrating the fabrication of a focal plane array with its readout circuitry.

One of the challenges in successfully implementing a 3-D circuit package has been to bring connections for the interior circuit layers out to the exterior of the package so they can be readily addressed by the user. One method to accomplish this has been developed by Hughes Aircraft Company, the assignee of the present invention, and is referred to as the thermal gradient zone melt technique. This approach is described in M.J. Little et al., "The 3-D Computer", Proc. of IEEE Int'l. Conf. on Wafer Scale Integration,Jan. 3, 1989, pages 55-64. It involves the distribution of aluminum dots on the surface of a silicon wafer within which circuit layers have been fabricated. A device is heated to about 1,100° - 1,200° C, causing the aluminum dots to melt and dissolve into the underlying silicon. This produces a conductive feedthrough composed of an aluminum/silicon alloy extending into the wafer from the location of each dot, and having a much lower resistivity than the surrounding silicon. The feedthroughs extend down to the circuit layer and thereby provide an external electrical access. While successfully producing feedthroughs to the circuit layers, this technique is subject to density limitations in the zone melts, and can result in a feed-through capacitance that is excessive for certain applications.

In the area of focal plane arrays, a "loop hole" or "VIMIS" (vertically integrated metal-insulator-semiconductor) technique has been developed in which a chip of photodetector material is glued to readout circuitry. The photodetector is then thinned, and openings are etched through it to access contact pads for an integrated circuit on the other side of the chip. The openings are then metallized to provide electrical connections through the detector to the readout circuitry. This technique is described, for example, in Amingual, "Advanced Infrared Multiple Plane Arrays", SPIE Infrared and Optoelectronic Materials and Devices, Vol. 1512, 1991, pages 40-51. However, it is limited to n on p detectors and has a fill factor limitation, meaning that the etched openings through the photodetector reduce the amount of material left to perform the photodetection function. Since the detector substrate must be relatively thick, the etched openings expand to undesirably large dimensions towards the surface of the photodetector.

Another focal plane array assembly uses indium "bumps" to mechanically secure a detector chip to a cell processing chip, and to provide a matrix of electrical contacts therebetween. This technique is described in U.S. Pat. No. 4,740,700, assigned to Hughes Aircraft Company, and is also referred to in the Amingual reference mentioned above. Although the bumps establish interconnects between two interior layers of the overall device, they do not provide access to the readout circuitry from an exterior surface of the device.

JP-A-63213943 describes mutlilayer MOSFET structures. Each MOSFET IC layer is formed on a silicon substrate. The circuits are covered with a layer of insulating film for protection, and then bonded to the underside of the silicon substrate of the next layer by means of a polyimide adherent layer. Through holes are formed to provide electrical connections between successive layers.

The present invention seeks to provide a 3-D circuit assembly that does not suffer from the limitations described above in connection with the prior devices, that allows for a higher circuitry density and if desired a mix of process technologies or materials, that is readily expandable to add additional circuit layers as desired, and that does not use up photodetector area for other purposes when used for a focal plane array.

The present invention provides a three-dimensional (3-D) circuit assembly, comprising:
a substrate having first contact pads supported thereon;
a first integrated circuit (IC) layer positioned over and spaced from said substrate and having second contact pads on a first surface thereof facing said substrate ;
a first electrically insulative layer surmounting the second surface of said first IC layer opposite said first surface;
an electrically insulative adhering layer adhering said first IC layer and substrate together and electrically insulating them from each other;
at least one first electrical contact means extending through openings in said electrically insulative layer and said first integrated circuit layer and establishing electrical contact with one said second contact pad on said first IC layer; and
at least one second electrical contact means extending through openings in said electrically insulative layer, said first IC layer and said adhering layer and establishing electrical contact with one said first contact pad on said substrate.

The lower substrate may include a second IC layer with which electrical contact is established. Alternately, when the lower substrate serves as a photodetector, it is provided with pixel contact pads with which the electrical connections are made through the openings in the overlying layers. The openings are preferably lined with an insulative material to avoid shorting out the upper IC layer.

Although the bonding material used to secure the two parts of the assembly together will normally have a coefficient of thermal expansion that substantially differs from that of the lower substrate, it is made thin enough so that it substantially assumes the substrate's thermal movements. The upper IC and insulative layers likewise assume the thicker substrate's thermal movements. Additional IC layers can be fabricated over the upper insulative layer, with each additional IC layer electrically insulated from the IC layer immediately below by a respective insulative layer. A set of electrical contacts for each additional IC layer is fabricated through the IC and insulative layers above the subject IC layer in a manner similar to the electrical contacts for the first IC layer and the lower substrate. Each of these additional layers are also preferably thin enough to substantially assume the lower substrate's thermal movements.

These and other features and advantages of the invention will be apparent to those skilled in the art from the following detailed description, taken together with the accompanying drawings, in which:
FIGs. 1a, 1b and 1c are sectional views, not to scale, showing three successive stages in the fabrication of a 3-D circuit assembly in accordance with the invention;
FIGs. 2a and 2b are sectional views, not to scale, illustrating successive steps in the fabrication of a circuit assembly with at least one additional circuit layer to those employed in FIGS. la-lb; and
FIG. 3 is a sectional view, not to scale, of a focal plane array assembly that incorporates the invention.

The 3-D circuit assembly of the present invention makes it possible to fabricate a 3-D circuit structure from two or more standard wafers, each of which has its own circuit layer. The first step in the preferred fabrication method is illustrated in FIG. la. Two conventional bonded silicon wafers 2a and 2b are shown, with the upper wafer 2b inverted and secured to the lower wafer 2a by a thin layer of electrically insulating adhesive 4 that is cured after the wafers are positioned. Accurate wafer alignment techniques are available that have been developed in connection with the known bump bonding technology mentioned above.

Each wafer includes a relatively thick silicon substrate 6a, 6b, a thin electrically insulative silicon dioxide layer 8a, 8b on the silicon substrate, and a thin silicon-based IC layer 10a, 10b on the respective SiO₂ layers 8a and 8b. The insulator layer 8a may be omitted unless it is desired as an insulator for IC layer 10a. Insulator layer 8b is included, even if there is not a need for upper insulation of IC layer 10b, since layer 8b serves as an etch stop during the subsequent removal of the upper substrate 6b, as described below. Lower substrate 6a would not normally be removed, so insulator layer 8a serves only an insulating and not an etch stop function.

Typical thicknesses for the elements of each bonded wafer are 525 micrometers for the silicon substrates 6a, 6b, 0.2-2 micrometers for the SiO₂ layers 8a, 8b, and 0.2-2 micrometers. for the IC layers 10a, 10b. Details of the actual circuitry fabricated in the IC layers are not shown, but generally the circuitry itself would extend about 0.3 micrometers deep into the IC layers and can include devices such as transistors, capacitors, etc. Aluminum contact pads 12a, 12b are provided on the circuit faces of the two wafers 2a, 2b for making electrical contacts to their respective ICs through openings in a thin insulating film (not shown).

One of the advantages of the invention is that the circuitry on the two wafers may be formed with different process techniques, such as bipolar vs. CMOS (complementary metal-oxide-semiconductor); since the wafers are provided as standard items before being bonded together, they can be fabricated totally independent of each other. Furthermore, although silicon based circuits are illustrated, other materials such as GaAs could also be used: one material could be used for one wafer and other material for the other wafer so long as they are compatible with the interconnections provided between the two. There is also flexibility in the choice of material for the isolation layers 8a and 8b; aluminum nitride or silicon nitride might be substituted for silicon dioxide.

The silicon substrates 6a, 6b and silicon-based IC layers 10a, 10b will generally have similar coefficients of thermal expansion, but this coefficient will generally be different from the temperature coefficients for the isolation layers 8a, 8b and the adhesive 4. While this might ordinarily be expected to result in the possibility of cracking over the normal design temperature range of -55° C - 125° C, the adhesive layer 4 is kept to a few micrometers in thickness. The thin dimensions for both the adhesive and isolation layers cause them to effectively assume the thermal expansion coefficient of the much thicker silicon substrate 6a to which they are bonded, so that the thermal expansion and contraction of the adhesive and isolation layers is controlled by and generally matches the thermal expansion of the silicon substrate. This stretching of the thinner material layers inhibits either cracking or delamination when significant temperature differentials are encountered.

A suitable material for the adhesive layer 4 is produced by Ablestick, Inc. under the designation GA47-2LV. Instead of the adhesive layer 4, thin layers of a fusible bonding material such as high temperature glass could be used, with the wafers bonded together by heating the fusible material. In this event the thickness of the bonding layer would still preferably be restricted to a few micrometers.

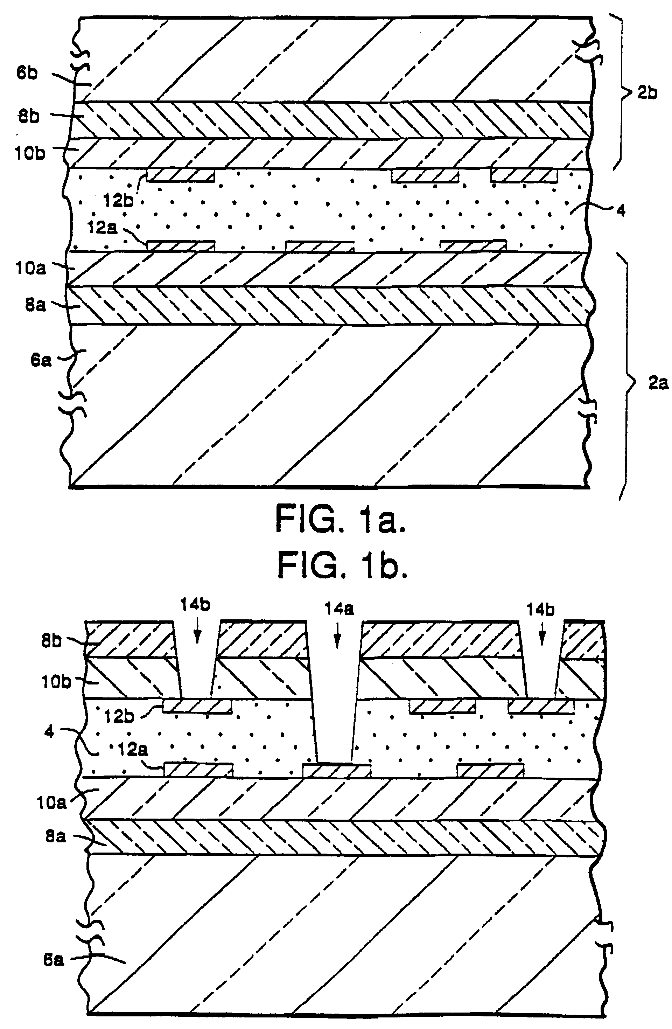

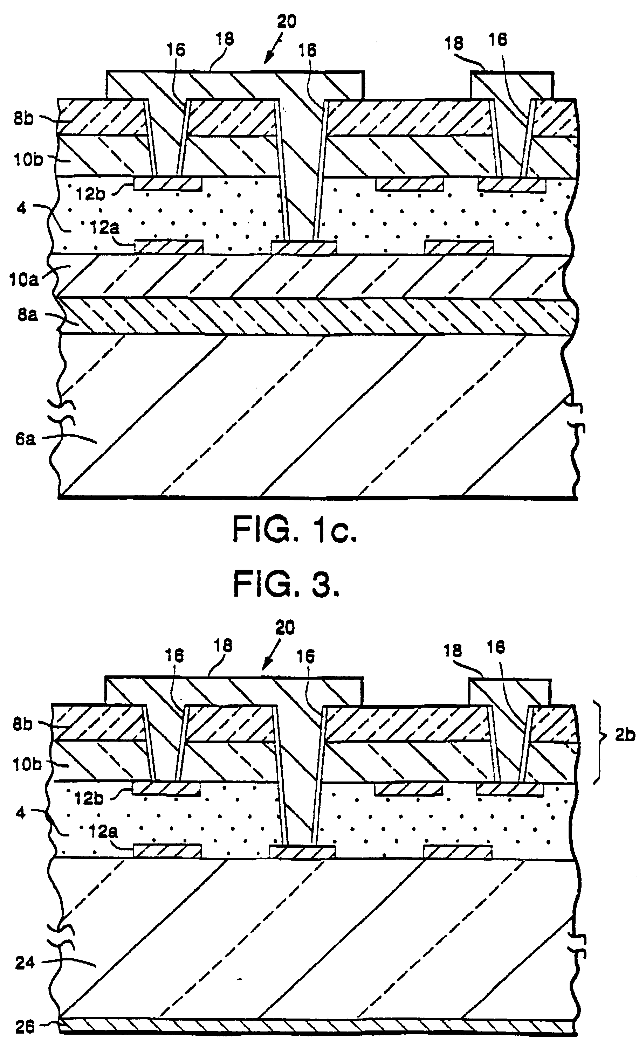

In the next fabrication steps, the results of which are illustrated in FIG. 1b, the upper substrate 6b has been removed, preferably by etching it away while using the SiO₂ layer 8b as an etch stop. Alternately, the substrate 6b can be removed first and the remaining IC layer 10b and insulative layer 8b aligned to the underlying wafer 2a with the assistance of an intermediate carrier. Openings are then made through the assembly to access selected contact pads 12a, 12b, and thus expose a path to electrically contact the portions of the circuitry to which these pads are connected.

The contact pad 12b for the IC layer 10b are accessed with via openings 14b through the upper SiO₂ layer 8b and IC layer 10b, while the contact pads 12a for the lower IC layer 10a are accessed with via openings via 14a through the upper SiO₂ layer 8b, upper IC layer 10b and the adhesive layer 4. Presently available trenching techniques, such as disclosed in Copper, et al., "Physical and Electrical Characteristics of Submicron Trench Capacitors", Extended Abstracts. The Electrochemical Society, Vol. 90-2, Oct. 14-19, 1990, pages 410-411; and Patent No. 4,702,795 to Douglas, permit these openings to be kept to a few microns in diameter or less. Since the relatively thick upper substrate 6b has been removed before the openings are made, the openings need extend only through the thin layers 8b, 10b and 4, and thus any spreading is minimized.

The via openings 14a and 14b can be formed by either chemical etching or reactive ion etching. Although trenching to the contact pads 12a and 12b is illustrated, the via openings 14a and 14b could also be established to desired metallization locations directly on the ICs themselves; the metallization of either the ICs or contact pads are preferably used as an etch stop. The via opening locations are controlled by a conventional mask technique, in which the upper SiO₂ layer 8b can function as the etch mask.

FIG. 1c shows a later stage in the device's fabrication. The sidewalls of the via openings have been coated with respective sleeves 16 of an insulative material such as glass (SiO₂). The sleeves 16 are applied by a process such as chemical vapor deposition, with the insulative coating removed from the bottoms of the via openings preferably by a photoetching process, either reactive ion etching or hydrofluoric acid. A metallization 18, preferably aluminum, is then deposited over the upper surface of the SiO₂ layer 8b and into the via openings, through which it forms electrically conductive members that establish electrical connections to their respective contact pads 12a and 12b. The sleeves 16 insulate the electrical contacts from the surrounding IC layer 10b.

The metallization layer on the upper surface of SiO₂ layer 8b is next photoetched to establish desired interconnections between the contact pads for the two IC layers 10a and 10b. Where desired, the metallization layer may be left intact so as to extend over the surface of SiO₂ layer 8b and interconnect a contact to one IC layer with a contact to the other; such an interconnection is indicated by numeral 20.

At this point the device may be considered to be essentially complete, and the wafer can be tested and diced using conventional techniques. The result is a set of high density 3-D circuit chips that have a sturdy construction, are useable over the full normal temperature range, and can have different circuit layers that employ different circuitry processes and even different materials.

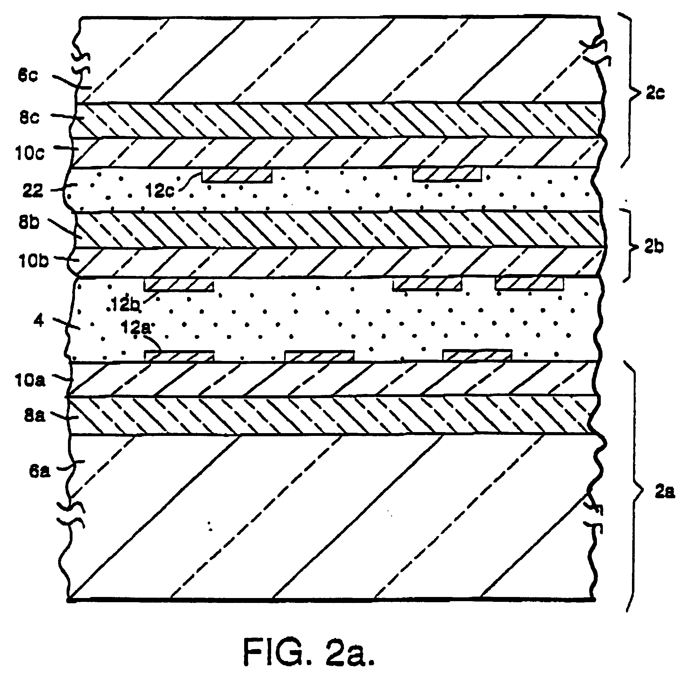

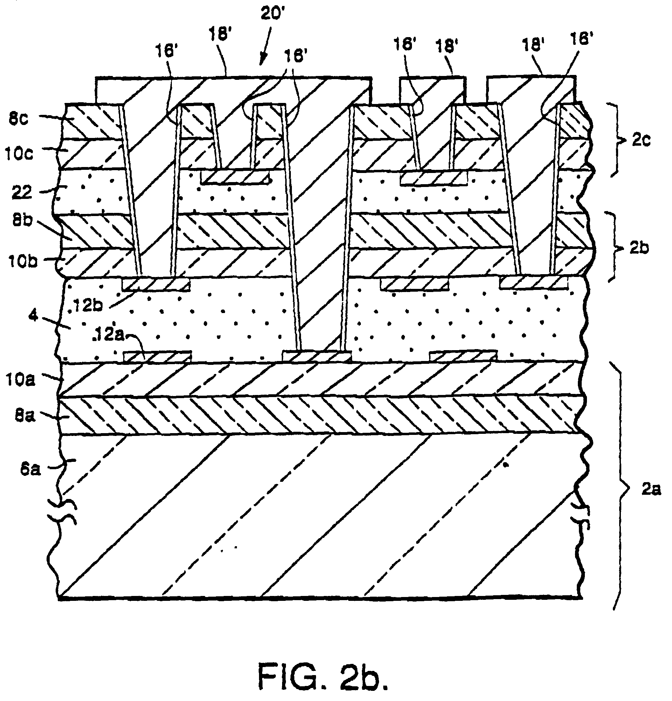

A variation of the 3-D circuit package and fabrication technique of FIGs. 1a-1c is illustrated in FIGs. 2a and 2b. In FIG. 2a a third conventional bonded wafer 2c has been inverted and adhered to the SiO₂ isolation layer 8b of the wafer 2b, after the removal of the upper substrate 6b (FIG. 1a) from wafer 2b. The new wafer 2c consists of a silicon (or other desired semiconductor) substrate 6c, an insulation layer 8c and an integrated circuit layer 10c with associated contact pads 12c. It is adhered to the underlying insulation layer 8b by a thin layer of adhesive or fusion bonded material 22 similar to the adherent material 4. The uppermost water's insulating layer 8c, IC layer 10c and adherent layer 22 are again thin enough so that they each expand and contract along with the much thicker bottom substrate 6a.

After the upper wafer 2c has been attached its substrate 6c is etched away. Alternately, the substrate 6c can be removed first and the remainder of the wafer aligned and adhered to the lower assembly with the assistance of an intermediate carrier. Openings are then etched to selected contact pads for the three different IC layers, as illustrated in FIG. 2b, in a manner similar to the formation of the access openings shown in FIG. 1c, and the openings are lined with insulating sleeves 16'. A metallization 18' is then applied to the upper surface of the top SiO₂ layer 8c and into the access openings, where it is insulated from the surrounding IC layers by the insulating sleeves. As with the embodiment or Fig. 1c, the metallization 18' is etched to leave desired metal interconnects 20' extending across the surface of upper SiO₂ layer 8c and thereby interconnect selected contact pads at different levels in the device, while removing the metallization from the areas where it is not needed.

Additional IC layers can be added in a similar fashion. However, the circuit density achievable with each additional layer will be progressively reduced somewhat, since the upper IC layers are traversed by both their own leads (if their contact pads are on their underside) and by the leads for all of the lower IC layers. Furthermore, since the provision of additional layers increases the total thickness of the material that must be etched to access the lower IC layers, the access openings for those layers will tend to spread somewhat as they approach the upper surface of the package, thus further reducing the area available for circuitry in the upper layers.

Another application of the invention is for the detection of electromagnetic radiation, such as with an infrared focal plane array. As example of this application is shown in FIG. 3. Instead of the lower bonded wafer 2a of FIGs. 1a-1c and 2a-2b, a lower substrate 24 formed from a suitable photodetector material such as HgCdTe/CdTe is used to sense IR radiation that strikes the underside of the package. The photodetection can be accomplished either with a photoconductive material whose resistance is sensitive to radiation, or with a photovoltaic material whose voltage is sensitive to radiation. The radiation first passes through an anti-reflection coating sheet 26 on substrate 24, which is organized into a matrix of pixels, each pixel being provided with a respective pixel contact pad 12a on the upper surface of the substrate. With a photoconductive substrate, a voltage is supplied to electrode 26 and the voltage drop across the substrate 24 is determined for each pixel by the amount that pixel is illuminated by the radiation of interest. With a photovoltaic substrate, a contact (not shown) is made to the same surface or substrate 24 as the contacts 12a, and a voltage is dropped across photodiode depletion region of substrate 24.

The IC layer 10b and insulative layer 8b of the upper wafer 2b are adhered to the photodetector substrate 24 in a manner similar to the previously described embodiments. The readout circuitry for the focal plane array is provided in the IC layer 10b, and is interconnected with the various pixel contact pads 12a by metallized interconnections as in the previous embodiments. The result is a unitary focal plane array package that has a capacity for a high density readout circuitry layer integrated with the photodetector. If desired, additional layers of readout circuitry can be provided as illustrated in FIGs. 2a and 2b.

While different embodiments of a high density circuit assembly and an associated fabrication method have thus been shown and described, numerous variations and alternate embodiments will occur to those skilled in the art. Accordingly, it is intended that the invention limited only in terms of the appended claims.

## Claims

1. A three-dimensional (3-D) circuit assembly, comprising:
a substrate (6a, 8a, 10a; 24) having first contact pads (12a) supported thereon;
a first integrated circuit layer (10b) positioned over and spaced from said substrate (6a) and having second contact pads (12b) on a first surface thereof facing said substrate ;
a first electrically insulative layer (8b) surmounting the second surface of said first IC layer (10b) opposite said first surface;
an electrically insulative adhering layer (4) adhering said first IC layer (10b) and substrate (6a, 8a, 10a; 24) together and electrically insulating them from each other;
at least one first electrical contact means (18) extending through openings in said electrically insulative layer (8b) and said first integrated circuit layer (10b) and establishing electrical contact with one said second contact pad (12b) on said first IC layer (10b); and
at least one second electrical contact means (18) extending through openings in said electrically insulative layer (8b), said first IC layer (10b) and said adhering layer (4) and establishing electrical contact with one said first contact pad (12a) on said substrate (6a).

2. The 3-D circuit assembly of Claim 1, wherein a second IC layer (10a) is provided at the surface of said substrate (6a) facing said first IC layer (10b), said first contact pads (12a) are formed on said second IC layer (10a), and said second electrical contact means (18) establishes electrical contact with said first contact pads (12a) on said second IC layer (10a).

3. The 3-D circuit assembly of Claim 1 or 2, wherein said first IC layer (10b) and first electrically insulative layer (8b) are each substantially thinner than said substrate (6a) so as to substantially assume the thermal movements of said substrate.

4. The 3-D circuit assembly of any preceding claim, wherein said adherent layer (4) is formed of thermally fusible insulative material.

5. The 3-D circuit assembly of any preceding claim wherein said first electrically insulative layer (8b) and adherent layer (4) are each substantially thinner than said substrate (6a) so as to substantially assume the thermal movements of said substrate (6a).

6. The 3-D circuit assembly of any preceding claim, further comprising an additional IC layer (10c) having at least one third contact pad (12c) on a surface thereof, said additional IC layer (10c) being arranged such that said surface having said third contact pad (12c) thereon faces said first insulative layer (8b) and is adhered thereto by a second electrically insulative adherent layer (22), said assembly further comprising an additional set of electrical contact means (18') extending through the additional IC . layer (10c) .

7. The 3-D circuit assembly of Claim 1, wherein said substrate (24) comprises a photodetector and said first contact pads (12a) are an array of pixel contact pads facing said first IC layer (10b), and said second electrical contact means (18) comprises discrete electrically conductive members extending through said first insulative layer (8b), first IC layer (10b) and adhering layer (4) and establishing electrical contacts with respective pixel contact pads (12a).

## Patentansprüche

1. Dreidimensionale Schaltungsanordnung (3-D), welche folgendes enthält:
ein Substrat (6a, 8a, 10a; 24), welches erste Kontaktflecken (12a) trägt;
eine erste integrierte Schaltungsschicht (12b), welche im Abstand über dem Substrat (6a, 8a, 10a; 24) angeordnet ist und zweite Kontaktflecken (12b), auf einer ersten seiner Oberflächen aufweist, welche dem Substrat zugekehrt ist;
eine erste elektrisch isolierende Schicht (8b), welche sich über der zweiten Oberfläche der ersten integrierten Schaltungsschicht (10b) der genannten ersten Oberfläche gegenüberliegend befindet;
eine elektrisch isolierende Haftungsschicht (4), welche die erste integrierte Schaltungsschicht (10b) und das Substrat (6a, 8a, 10a; 24) zusammenhält und diese Teile elektrisch voneinander isoliert;
mindestens ein erstes elektrisches Kontaktmittel (18), das sich durch Öffnungen in der genannten elektrisch isolierenden Schicht (8b) und der genannten ersten integrierten Schaltungsschicht (10b) erstreckt und elektrische Verbindung mit einem der genannten zweiten Kontaktflecken (10b ) auf der ersten integrierten Schaltungsschicht (10b) herstellt; und
mindestens ein zweites elektrisches Kontaktmittel (18), das sich durch Öffnungen in der genannten elektrisch isolierenden Schicht (8b), der ersten integrierten Schaltungsschicht (10b) und der Haftungsschicht (4) erstreckt und elektrische Verbindung mit einem der genannten ersten Kontaktflecken (12a) auf dem genannten Substrat (6a, 8a, 10a; 24) herstellt.

2. 3-D-Schaltungsanordnung nach Anspruch 1, bei welcher eine zweite integrierte Schaltungsschicht (10a) an derjenigen Oberfläche des genannten Substrates (6a) vorgesehen ist, welche der genannten ersten integrierten Schaltungsschicht (10b) zugekehrt ist, wobei die ersten Kontaktflecken (12a) auf der genannten zweiten integrierten Schaltungsschicht (10a) gebildet sind und das genannte zweite elektrische Kontaktmittel (18) elektrische Verbindung mit den ersten Kontaktflecken (12a) auf der zweiten integrierten Schaltungsschicht (10a) herstellt.

3. 3-D-Schaltungsanordnung nach Anspruch 1 oder 2, bei welcher die erste integrierte Schaltungsschicht (10b) und die erste elektrisch isolierende Schicht (8b) jeweils wesentlich dünner als das genannte Substrat (6a) sind, so daß sie thermisch bedingt Bewegungen des Substrates im wesentlichen mitmachen.

4. 3-D-Schaltungsanordnung nach einem der vorhergehenden Ansprüche, bei welcher die genannte Haftungsschicht (4) aus thermisch schmelzbarem Isolationsmaterial gebildet ist.

5. 3-D-Schaltungsanordnung nach einem der vorhergehenden Ansprüche, bei welcher die erste elektrisch isolierende Schicht (8b) und die Haftungsschicht (4) jeweils wesentlich dünner als das Substrat (6a) sind, so daß sie im wesentlichen thermische Bewegungen des Substrates (6a) mitmachen.

6. 3-D-Schaltungsanordnung nach einem der vorhergehenden Ansprüche, welche weiter eine zusätzliche integrierte Schaltungsschicht (10c) enthält, die auf einer ihrer Oberflächen mindestens einen dritten Kontaktflecken (12c) aufweist, wobei die zusätzliche integrierte Schaltungsschicht (10c) derart angeordnet ist, daß die mit dem bzw. den dritten Kontaktflecken (12c) versehene Oberfläche der ersten isolierenden Schicht (8b) zugekehrt ist und an dieser durch eine zweite elektrisch isolierende Haftungsschicht (22) anhaftend gehalten ist, wobei die Anordnung weiter eine zusätzliche Gruppe von elektrischen Kontaktmitteln (18), welche sich durch die zusätzliche integrierte Schaltungsschicht (10c) erstrecken, enthält.

7. 3-D-Schaltungsanordnung nach Anspruch 1, bei welcher das genannte Substrat (24) einen Fotodetektor enthält und die ersten Kontaktflecken (12a) eine Reihe von Pixel-Kontaktflecken sind, welche der ersten integrierten Schaltungsschicht (10b) zugekehrt sind, und wobei die zweiten elektrischen Kontaktmittel (18) diskrete elektrische Leiterelemente umfassen, welche sich durch die erste isolierende Schicht (8b), die erste integrierte Schaltungsschicht (10b) und die Haftungsschicht (4) erstrecken und elektrische Verbindung zu den jeweiligen Pixel-Kontaktflecken (12a) herstellen.

## Revendications

1. Ensemble formant circuit tridimensionnel, comprenant:
un substrat (6a, 8a, 10a ; 24) portant des premières plages de contact (12a) ;
une première couche de circuit intégré (10b), située au-dessus dudit substrat (6a) avec un écartement par rapport à celui-ci, et comportant des deuxièmes plages de contact (12b) sur une première surface, située en face dudit substrat ;
une première couche électriquement isolante (8b) , recouvrant la seconde surface de ladite première couche de circuit intégré (10b), située à l'opposé de ladite première surface ;
une couche adhérente électriquement isolante (4) pour relier ladite première couche de circuit intégré (10b) et ledit substrat (6a, 8a, 10a ; 24) et pour les isoler électriquement l'un par rapport à l'autre ;
au moins un premier moyen de contact électrique (18), qui s'étend dans des ouvertures présentes dans ladite couche électriquement isolante (8b) et dans ladite première couche de circuit intégré (10b), et qui établit un contact électrique avec l'une desdites deuxièmes plages de contact (12b), situées sur ladite première couche de circuit intégré (10b) ; et
au moins un deuxième moyen de contact électrique (18), qui s'étend dans des ouvertures présentes dans ladite couche électriquement isolante (8b), dans ladite première couche de circuit intégré (10b) et dans ladite couche adhérente (4), et qui établit un contact électrique avec l'une desdites premières plages de contact (12a), situées sur ledit substrat (6a).

2. Ensemble formant circuit tridimensionnel selon la revendication 1, dans lequel une deuxième couche de circuit intégré (10a) est prévue au niveau de la surface dudit substrat (6a), faisant face à ladite première couche de circuit intégré (10b), lesdites premières plages de contact (12a) étant formées sur ladite deuxième couche de circuit intégré (10a) , et ledit deuxième moyen de contact électrique (18) établissant un contact électrique avec lesdites premières plages de contact (12a), situées sur ladite deuxième couche de circuit intégré (10a).

3. Ensemble formant circuit tridimensionnel selon la revendication 1 ou 2, dans lequel ladite première couche de circuit intégré (10b) et ladite première couche électriquement isolante (8b) sont chacune sensiblement plus minces que ledit substrat (6a), de manière à épouser sensiblement les mouvements thermiques dudit substrat.

4. Ensemble formant circuit tridimensionnel selon l'une quelconque des revendications précédentes, dans lequel ladite couche adhérente (4) est constituée d'une matière isolante fondant à la chaleur.

5. Ensemble formant circuit tridimensionnel selon l'une quelconque des revendications précédentes, dans lequel ladite première couche électriquement isolante (8b) et ladite couche adhérente (4) sont chacune sensiblement plus minces que ledit substrat (6a), de manière à épouser sensiblement les mouvements thermiques dudit substrat (6a).

6. Ensemble formant circuit tridimensionnel selon l'une quelconque des revendications précédentes, comprenant en outre une couche de circuit intégré supplémentaire (10c) présentant, sur une surface, au moins une troisième plage de contact (12c) , ladite couche de circuit intégré supplémentaire (10c) étant prévue de telle manière que ladite surface, portant ladite troisième plage de contact (12c), soit située en face de ladite première couche isolante (8b) et y adhère au moyen d'une deuxième couche adhérente électriquement isolante (22), ledit ensemble comprenant en outre un jeu supplémentaire de moyens de contact électrique (18'), qui traverse ladite couche de circuit intégré supplémentaire (10c).

7. Ensemble formant circuit tridimensionnel selon la revendication 1, dans lequel ledit substrat (24) comprend un photodétecteur et dans lequel lesdites premières plages de contact (12a) sont un groupement de plages de contacts de pixels faisant face à ladite première couche de circuit intégré (10b), et dans lequel ledit deuxième moyen de contact électrique (18) comprend des éléments discrets électriquement conducteurs, qui s'étendent à travers ladite première couche isolante (8b), ladite première couche de circuit intégré (10b) et ladite couche adhérente (4), et qui établissent des contacts électriques avec les plages de contact de pixels (12a) respectives.
